# EUROPEAN PATENT APPLICATION

(11) **EP 2 506 314 A1**
(43) Date of publication of application: **03.10.2012**
(21) Application number: 10832650.5
(22) Date of filing: 24.11.2010
(51) Int. Cl.: H01L 31/18

(54) **MANUFACTURING METHOD OF FRONT ELECTRODE OF SOLAR CELL**

(30) Priority: 27.11.2009 CN 200910246221
(71) Applicant: Wuxi Suntech Power Co., Ltd., Wuxi, Jiangsu 214-028 (CN)
(72) Inventor: ZHANG, Guangchun, Wuxi Jiangsu 214028 (CN); WANG, Yichuan, Jiangsu 214000 (CN); YANG, Jian, Wuxi Jiangsu 214028 (CN); CHEN, Rulong, Jiangsu 214000 (CN); XUE, Xiaoxing, Wuxi Jiangsu 214028 (CN); GE, Jian, Jiangsu 214000 (CN); HUANG, Haitao, Wuxi Jiangsu 214028 (CN); WANG, Yihua, Wuxi Jiangsu 214028 (CN); ZHOU, Jie, Wuxi Jiangsu 214028 (CN); WANG, Tao, Wuxi Jiangsu 214028 (CN); WANG, Yin, Wuxi Jiangsu 214028 (CN)
(74) Representative: Solf, Alexander
(86) International application number: PCT/CN2010/079065
(87) International publication number: WO 2011/063743

(57) **Abstract**

A method of forming a front electrode of a solar cell is provided, which comprises a step of forming a sub-grid line and a main-grid line on the solar cell. The method comprises steps of: forming a lower layer of the sub-grid line on the solar cell using a lower paste by a first screen; drying the solar cell that is formed with the lower layer of the sub-grid line; forming an upper layer of the sub-grid line and the main-grid line simultaneously on the solar cell using an upper paste by a second screen; and sintering the solar cell that is formed with the sub-grid line and the main-grid line. With this invention, a height-width ratio of the sub-grid line is increased, and no redundant recombination is generated at the position of the main-grid line. As such, the paste cost can be reduced effectively, and at the same time the internal stress generated at the electrode when the module is soldered during production can be reduced. A method of manufacturing a solar cell using the methods described above is provided and a solar cell manufactured by the method described above is also provided.

## Description

### FIELD OF THE INVENTION

The present invention relates to the field of manufacturing a photovoltaic cell and, more particularly, to a method of forming an electrode of a solar cell.

### BACKGROUND OF THE INVENTION

Recently, in the development of an alternative energy, significant breakthroughs have been achieved in a solar cell technique, and the application of the solar cell has been becoming wider and wider. The screen printing process, due to the mature technique, a simple process and an easier control in accuracy, has been widely used for manufacturing a front electrode of a solar cell in a photovoltaic industry. However, the limitation of the screen printing technique has been exposed gradually under the tendency of demanding the solar cell to be higher efficiency and lower cost.

It is well known in the manufacturing process of a solar cell that, the higher a sub-grid line of the solar cell is, the lower the resistance of the sub-grid line will be; when the width of the sub-grid line become greater, the resistance of the sub-grid line will be similarly reduced, but an effective light-receiving area will be reduced, which means the loss overweighs the gain. On the contrary, the light-receiving area will be increased if the width of the sub-grid line becomes smaller, whereby a conversion efficiency of the solar cell can be improved accordingly. As such, it is preferable to make the sub-grid line of the solar cell thinner and higher, that is, the greater a height-width ratio of the sub-grid line is, the better it is. In the conventional screen printing, when a printing height of a paste becomes greater, the width thereof may become greater under the influence of the rheological property of the paste used therefor. In addition, influenced by the film thickness of a screen stencil used therefor, the ink amount of the printing paste penetrating through the screen stencil is limited, which results in the height of the printed paste is limited. Furthermore, the function of the sub-grid line is not completely the same as that of the main-grid line in the solar cell. More specifically, the sub-grid line is mainly used to collect the photo-generated current generated in the solar cell, while the main-grid line electrically connected to the sub-grid line is used to gather and output the current collected by the sub-grid line. Thus the sub-grid line is required to form ohmic contact with the solar cell while the main-grid line is not required to do so. However, in the conventional screen printing process in which the main-grid line and the sub-grid line are printed simultaneously by using one type of paste, in order to increase the height of the sub-grid line as much as possible, the height of the main-grid line will be inevitably increased thereupon. However, the increase in the height of the main-grid line not only contributes less to the electrical characteristic, but also increases the paste loss and thus the cost. Meanwhile, the excessively high main-grid line may cause the increased soldering debris in the module, resulting in the abandonment of the solar cell. Thus, the height-width ratio of the sub-grid line of the solar cell can hardly be improved further in accordance with the prior screen printing process. Moreover, the same paste is used for the main-grid line and the sub-grid line in the conventional screen printing process such that both the main-grid line and the sub-grid line may penetrate through an anti-reflection (passivation) coating during metallization sintering, and redundant recombination may thus be generated at the position of the main-grid line, thereby reducing the electrical characteristic of the solar cell.

In the conventional screen printing process, as a consequence of the simultaneously printing of the main-grid line and the sub-grid line by using one type of paste, the front electrode of the solar cell, in particular the sub-grid line, is incapable of achieving a functional delamination, for example, the lower layer of the grid line is in ohmic contact with the solar cell for collecting the current and the upper layer thereof is only for conducting electricity.

In general, the conventional screen printing process involves only one time printing, that is to say, the printing of the main-grid line and the sub-grid line by using one type of paste is performed simultaneously. Since the effect of the ohmic contact between the front electrode and silicon needs to be taken into consideration, the sheet resistance of a silicon wafer with a diffused layer thereon can only be controlled to a lower level, which inevitably causes a loss in the current. And more additional procedures need to be added if the locally heavy doping is carried out by the means of mask or etch windowing, making the production procedures more complicated and increasing the production cost.

### SUMMARY OF THE INTENTION

An aspect of the invention is to provide a method of forming a front electrode of a solar cell, by which a height-width ratio of a sub-grid line can be increased in the condition that a height of a main-grid line remains unchanged.

A further aspect of the invention is to provide a method of forming a front electrode of a solar cell, by which redundant recombination can be prevented from being generated at the position of a main-grid line and thus electrical characteristic of the solar cell can be improved.

A further aspect of the invention is to provide a method of forming a front electrode of a solar cell, by which a front electrode of a solar cell, particularly a sub-grid line, can be delaminated functionally.

A yet further aspect of the invention is to provide a method of forming a front electrode of a solar cell, by which heavy doping at the position of the electrode can be achieved during sintering and thus ohmic contact at the position of the electrode can be improved, which can effectively improve a current when the sheet resistance of the whole silicon wafer increases.

To this end, the present invention provides a method of forming a front electrode of a solar cell, comprising a step of forming the sub-grid line and the main-grid line on the solar cell, wherein the method comprises steps of:
forming a lower layer of the sub-grid line on the solar cell using a lower paste by a first screen;
drying the solar cell that is formed with the lower layer of the sub-grid line;
forming an upper layer of the sub-grid line and the main-grid line on the solar cell simultaneously using an upper paste by a second screen; and
sintering the solar cell that is formed with the sub-grid line and the main-grid line.

It is preferable that the method further comprises a step of carrying out at least one time printing at the position on the solar cell where the sub-grid line needs to be provided using the upper paste by the first screen, following said step of forming the main-grid line and the upper layer of the sub-grid line on the solar cell simultaneously using the upper paste by the second screen.

It is preferable that in the step of sintering the solar cell that is formed with the sub-grid line and the main-grid line, the lower paste penetrates through a passivation coating of the solar cell to form ohmic contact with a base silicon layer of the solar cell.

It is preferable that the upper paste does not penetrate through a passivation coating of the solar cell in the step of sintering the solar cell that is formed with the sub-grid line and the main-grid line.

It is preferable that the upper paste has a strengthened conductive characteristic.

It is preferable that the lower paste has been added with an element of Group V.

It is preferable that said step of sintering the solar cell that is formed with the sub-grid line and the main-grid line further comprises:
making the element of Group V bond with silicon in the solar cell through sintering.

It is preferable that a width of the sub-grid line is decreased upwardly from the lower layer thereof layer by layer.

Another aspect of the present invention further provides a method of forming a front electrode of a solar cell, comprising a step of forming a sub-grid line and a main-grid line on the solar cell, wherein the method comprises steps of:
forming a lower layer of the sub-grid line on the solar cell using a lower paste by a first screen;
carrying out the first sintering on the solar cell that is formed with the lower layer of the sub-grid line such that the lower paste penetrates through a passivation coating of the solar cell to form ohmic contact with a base silicon layer of the solar cell;
forming an upper layer of the sub-grid line and the main-grid line on the solar cell simultaneously using an upper paste by a second screen; and
carrying out the second sintering on the solar cell that is formed with the sub-grid line and the main-grid line, wherein the main-grid line does not form ohmic contact with the base silicon layer of the solar cell at the position of the main-grid line.

A yet further aspect of the invention is to provide a method of manufacturing a solar cell, which comprises steps of forming a front electrode on the solar cell by the method described above.

A yet further aspect of the invention is to provide a solar cell, which comprises a front electrode of the solar cell that is formed by the method described above.

The sub-grid line can be formed separately from the main-grid line of the solar cell according to the present invention. Therefore, the sub-grid line may be printed many times in a condition that the height of the main-grid line is guaranteed to be unchanged. As such, the height-width ratio of the sub-grid line is increased, and an optimal fill factor can be obtained under the condition of the same shaded area, which causes an increased photoelectric conversion efficiency and an increased output electrical characteristic of the solar cell module.

Moreover, only the sub-grid line is made ohmic contact with silicon, so that redundant recombination is prevented from being generated at the position of the main-grid line. As such, the paste cost can be reduced effectively without affecting the electrical characteristic, and at the same time the internal stress generated at the electrode when the module is soldered during production can be reduced, whereby the reliability of the solar cell can be enhanced.

Due to the difference in the components of the lower paste and the upper paste, the lower paste after being sintered penetrates through the passivation coating of the solar cell to form ohmic contact with the silicon layer of the solar cell, and the upper paste has good conductive characteristic but does not penetrate through the passivation coating, so that the front electrode of the solar cell, particularly the electrode at the position of the sub-grid line, can be formed as two layers having different functions, thereby achieving the functional division. The recombination problem occurring at the position of the main-grid line in the conventional technique can be avoided due to no ohmic contact between the main-grid line and the solar cell, and thus the electrical characteristic of the solar cell can be improved.

Adding the element of Group V into the lower paste enables the heavy doping at the position of the electrode during the sintering. This can improve the ohmic contact at the position of the electrode, and in combination with the increased sheet resistance of the whole silicon wafer, it can effectively enhance the output electrical characteristic of the solar cell.

### BRIEF DESCRIPTION OF THE DRAWINGS

Fig. 1 is a flowchart of an embodiment illustrating a method of forming a front electrode of a solar cell in accordance with the present invention;
Fig. 2 is a flowchart of another embodiment illustrating a method of forming a front electrode of a solar cell in accordance with the present invention; and
Fig. 3 is a flowchart of a further embodiment illustrating a method of forming a front electrode of a solar cell in accordance with the present invention.

### DETAILED DESCRIPTION OF PREFERRED EMBODIMENTS

The technical aspect of an embodiment of the invention will be described clearly and completely below with reference to the accompanying drawings for the embodiment of the invention. It is apparent that examples described are part of the embodiments of the invention, but not all the embodiments. All the other embodiments obtained by one skilled in the art based on the embodiments of the invention under the premise that no creative labor is made fall within the protection scope of the invention.

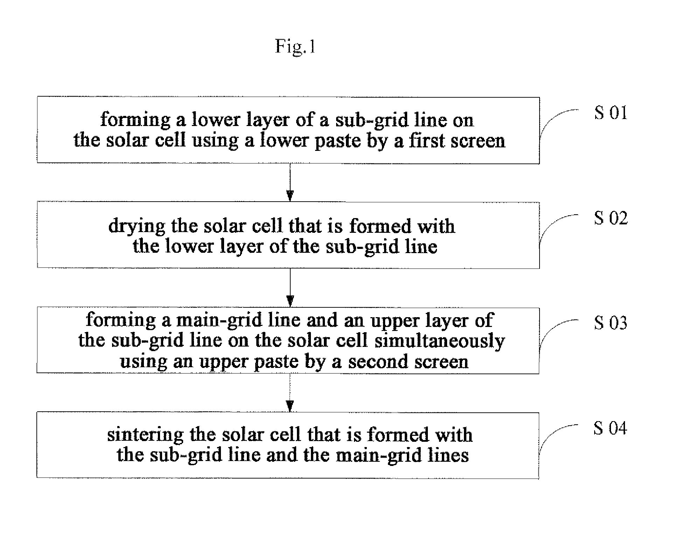

Fig. 1 is a flowchart of an embodiment illustrating a method of forming a front electrode of a solar cell in accordance with the present invention. As illustrated in Fig. 1, the method of forming a front electrode of a solar cell in this embodiment comprises:
S01: forming a lower layer of a sub-grid line on the solar cell using a lower paste by a first screen;
S02: drying the solar cell that is formed with the lower layer of the sub-grid line;
S03: forming a main-grid line and an upper layer of the sub-grid line on the solar cell simultaneously using an upper paste by a second screen; and
S04: sintering the solar cell that is formed with the sub-grid line and the main-grid line.

In this embodiment, firstly, the lower layer of the sub-grid line is formed on the solar cell using the lower paste by the first screen which may be preset as desired, and have the pattern of the sub-grid line only, and only be used to print at the position of the sub-grid line. Thus, only the lower layer of the sub-grid line is printed at step S01, while the position of the main-grid line is not printed. The solar cell is then dried, and thereafter the main-grid line and the upper layer of the sub-grid line are formed on the solar cell simultaneously using the upper paste by the second screen having the patterns of the sub-grid line and the main-grid line thereon. Then the solar cell is sintered such that after the sintering process, only the lower layer of the sub-grid line penetrates through a passivation coating on the surface of the solar cell to form ohmic contact with a silicon base at the position of the sub-grid line.

As such, a height-width ratio of the sub-grid line is effectively increased and the height of the main-grid line remains unchanged as compared to the prior art in which the main-grid line and the sub-grid line are printed once together, because the electrode of the sub-grid line is printed twice and the electrode at the position of the main-grid line is printed once only. In addition, after the sintering process, only the lower layer of the sub-grid line penetrates through the passivation coating on the surface of the solar cell to form ohmic contact with the silicon base, while no ohmic contact is formed at the position of the main-grid line such that the recombination at the position of the main-grid line can be prevented and further the output electrical characteristic of the solar cell module can be improved. Furthermore, in a condition that the output electrical characteristic of the solar cell is not be influenced, the cost of paste is effectively reduced, and the internal stress generated at the electrode when the module is soldered during production is reduced as well, and therefore the reliability of the solar cell can be enhanced.

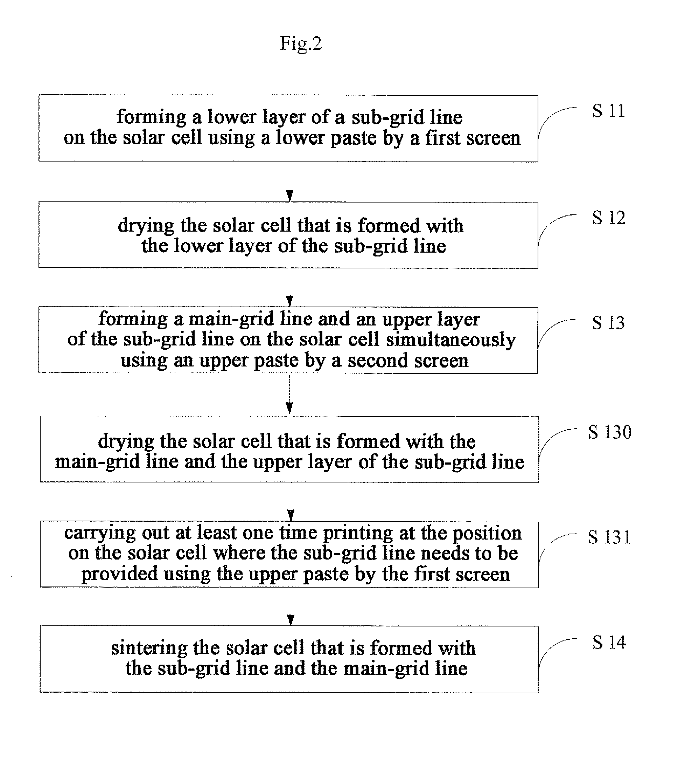

Fig. 2 is a flowchart of another embodiment illustrating a method of forming a front electrode of a solar cell in accordance with the present invention. As illustrated in Fig. 2, the method of forming a front electrode of a solar cell in accordance with this embodiment comprises:
S11: forming a lower layer of a sub-grid line on the solar cell using a lower paste by a first screen;
S12: drying the solar cell that is formed with the lower layer of the sub-grid line;
S 13: forming a main-grid line and an upper layer of the sub-grid line on the solar cell simultaneously using an upper paste by a second screen;
S130: drying the solar cell that is formed with the main-grid line and the upper layer of the sub-grid line;
S 131: carrying out at least one time printing at the position on the solar cell where the sub-grid line needs to be provided using the upper paste by the first screen; and
S14: sintering the solar cell that is formed with the sub-grid line and the main-grid line.

In this embodiment, firstly, the lower layer of the sub-grid line is formed on the solar cell using the lower paste by the first screen which may be preset as desired, and have the pattern of the sub-grid line only, and only be used to print at the position of the sub-grid line rather than the position of the main-grid line. The solar cell is then dried, and thereafter the main-grid line and the upper layer of the sub-grid line are formed on the solar cell simultaneously using the upper paste by the second screen having the patterns of the sub-grid line and the main-grid line thereon. Next, multiple printings are performed at the position on the solar cell where the sub-grid line needs to be provided using the upper paste by the first screen. Then the solar cell is sintered such that after the sintering process, only the lower layer of the sub-grid line penetrates through a passivation coating on the surface of the solar cell to form ohmic contact with a silicon base at the position of the sub-grid line.

As the first screen is preset and only used to print at the position of the sub-grid line, the position of the sub-grid line can be printed multiple times by the first screen after the step S13, so that the height-width ratio of the electrode of the sub-grid line can be increased significantly; whereas the height of the electrode of the main-grid line is kept unchanged and there is no ohmic contact with the silicon base at the position of the main-grid line. As such, the height-width ratio of the sub-grid line is effectively increased, and the recombination at the position of the main-grid line is prevented, so that the output electrical characteristic of the solar cell module is improved, and the internal stress generated at the electrode when the module is soldered during production is reduced, and therefore the reliability of the solar cell can be enhanced.

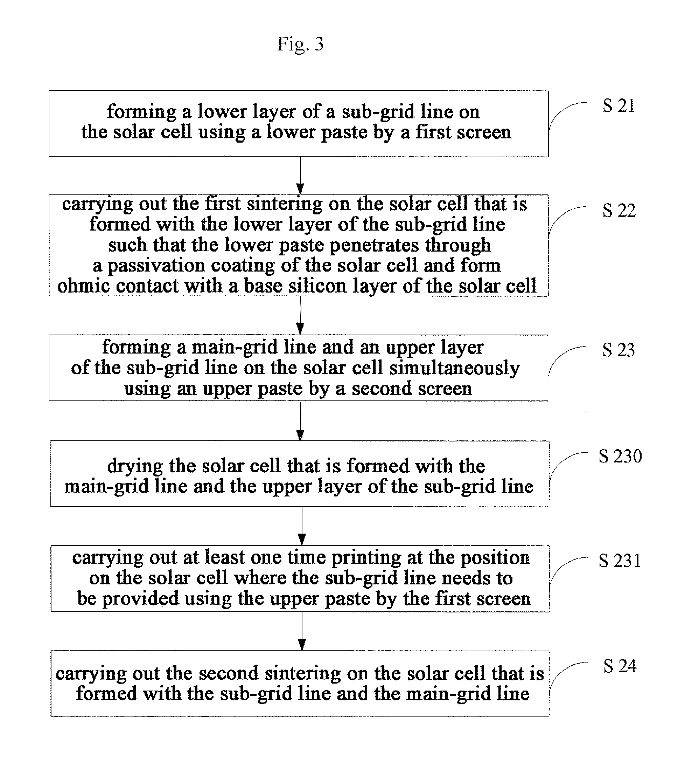

Fig. 3 is a flowchart of a further embodiment illustrating a method of forming a front electrode of a solar cell in accordance with the present invention. As illustrated in Fig. 3, the method of forming a front electrode of a solar cell in accordance with this embodiment comprises:
S21: forming a lower layer of a sub-grid line on the solar cell using a lower paste by a first screen;
S22: carrying out the first sintering on the solar cell that is formed with the lower layer of the sub-grid line such that the lower paste penetrates through a passivation coating of the solar cell to form ohmic contact with a lower silicon layer of the solar cell;
S23: forming a main-grid line and an upper layer of the sub-grid line on the solar cell simultaneously using an upper paste by a second screen;
S230: drying the solar cell that is formed with the main-grid line and the upper layer of the sub-grid line;
S231: carrying out at least one time printing at the position on the solar cell where the sub-grid line needs to be provided using the upper paste by the first screen; and
S24: carrying out the second sintering on the solar cell that is formed with the sub-grid line and the main-grid line.

In this embodiment, firstly, the lower layer of the sub-grid line is formed on the solar cell using the lower paste by the first screen which may be preset as desired and only be used to print at the position of the sub-grid line rather than at the position of the main-grid line. The lower paste after being sintered penetrates through a passivation coating of the solar cell to form ohmic contact with a silicon layer of the solar cell. Next, the main-grid line and the upper layer of the sub-grid line are formed on the solar cell simultaneously using the upper paste by the second screen. Multiple printings are performed at the position on the solar cell where the sub-grid line needs to be provided using the upper paste by the first screen after the drying process, and thereafter the sintering process is performed.

It is preferable that the component of the lower paste is different from that of the upper paste used in the above method. Particularly, the lower paste is selected such that the paste is capable of penetrating through the anti-reflection (passivation) coating and having good ohmic contact with the silicon layer of the solar cell, thereby obtaining the lower contact resistance. In contrast to the lower paste, the paste that is not required to penetrate through the anti-reflection (passivation) coating but has better conductivity is selected as the upper paste. For example, in the upper paste, additives such as glass material and the like that are mainly advantageous for penetrating through the anti-reflection coating and additives that are mainly advantageous for forming ohmic contact are reduced, and the specific weight of additives contributing to the conductivity is increased. Thus, the front electrode of the solar cell, in particular the electrode at the position of the sub-grid line, may be divided functionally, and further no redundant recombination is generated at the position of the main-grid line. The lower paste, printed on the lower layer at the position of the sub-grid line at the steps S01, S11 and S21 for instance, penetrates through the anti-reflection (passivation) coating after being sintered to form ohmic contact with the silicon layer of the solar cell and form a lower contact resistance. The lower layer at the position of the sub-grid line is thus formed as a silicon-ohmic contact layer, the primary function of which is to be in good ohmic contact with the silicon layer of the solar cell and further form the lower contact resistance. Then at the steps S03, S13, S23, S131 and S231, multiple printings are performed at the position of the sub-grid line by using the upper paste, whereby the height-width ratio at the position of the sub-grid line is increased on one hand and a paste that is not required to penetrate through the anti-reflection (passivation) coating but has better conductivity can be selected for the upper paste on the other hand. As a result, the upper layer at the position of the sub-grid line is formed as a current transmitting layer with good characteristic such that the front electrode of the solar cell, in particular the electrode at the position of the sub-grid line, can be delaminated functionally. Furthermore, only the position of the sub-grid line is printed at steps S01, S11 and S21, and the component of the upper paste used in steps S03, S13, S23, S131 and S231 is mainly advantageous for electrical conduction and may not penetrate through the anti-reflection (passivation) coating. Accordingly, no redundant recombination may be generated since no contact is formed between the main-grid line and the silicon layer of the solar cell, thereby improving the electrical characteristic of the solar cell.

The sintering temperature for the lower paste may be different from that for the upper paste in the embodiment as illustrated in Fig. 3, for example, the sintering temperature of the first sintering is higher than that of the second sintering, which results in that only the lower paste of the sub-grid line may form contact with the base silicon layer of the solar cell while the main-grid line and the upper layer of the sub-grid line may not form contact with the base silicon layer of the solar cell, whereby the above objects are obtained.

Preferably, a width of the upper layer of the sub-grid line is less than that of the lower layer thereof according to the above method. That is, the width of the sub-grid line is decreased upwardly from the lower layer thereof layer by layer.

It is preferable in above methods that an element of Group V may be added into the lower paste. Specifically, locally heavy doping is performed in the electrode area at the position of the sub-grid line at steps S04, S14 and S22, i.e., the sintering. The bond of the element of Group V and silicon at the electrode position of the sub-grid line is achieved at high temperature during sintering, and an effect similar to P diffusion is achieved. The cost of the equipment is not further increased, because it is the simplest and fastest way to achieve heavy doping during sintering, which can effectively enhance the output electrical characteristic of the solar cell module when the sheet resistance increases.

A method of manufacturing a solar cell is further provided according to the invention, which comprises a step of forming a front electrode of the solar cell by the method described in the embodiments above.

A solar cell is further provided according to the invention, which comprises a front electrode formed by the method described in the embodiments above.

In all, the foregoing embodiments of the invention are intended to explain the invention, but not to define the protection scope of the invention. All the modifications, equivalent replacements and changes made within the spirit and principle of the present invention should be embraced by the protection scope of the invention.

## Claims

1. A method of forming a front electrode of a solar cell, comprising a step of forming a sub-grid line and a main-grid line on the solar cell, wherein the method comprises steps of:
forming a lower layer of the sub-grid line on the solar cell using a lower paste by a first screen;
drying the solar cell that is formed with the lower layer of the sub-grid line;
forming an upper layer of the sub-grid line and the main-grid line on the solar cell simultaneously using an upper paste by a second screen; and
sintering the solar cell that is formed with the sub-grid line and the main-grid line.

2. The method according to claim 1, wherein the method further comprises a step of carrying out at least one time printing at the position on the solar cell where the sub-grid line needs to be provided using the upper paste by the first screen, following said step of forming the main-grid line and the upper layer of the sub-grid line on the solar cell simultaneously using the upper paste by the second screen.

3. The method according to claim 1 or 2, wherein in the step of sintering the solar cell that is formed with the sub-grid line and the main-grid line, the lower paste penetrates through a passivation coating of the solar cell to form ohmic contact with a base silicon layer of the solar cell.

4. The method according to claim 1 or 2, wherein in the step of sintering the solar cell that is formed with the sub-grid line and the main-grid line, the upper paste does not penetrate through a passivation coating of the solar cell.

5. The method according to claim 1 or 2, wherein the upper paste has a strengthened conductive characteristic.

6. The method according to claim 1 or 2, wherein the lower paste has been added with an element of Group V.

7. The method according to claim 1 or 2, wherein a width of the sub-grid line is decreased upwardly from the lower layer thereof layer by layer.

8. A method of forming a front electrode of a solar cell, comprising a step of forming a sub-grid line and a main-grid line on the solar cell, wherein the method comprises steps of:
forming a lower layer of the sub-grid line on the solar cell using a lower paste by a first screen;
carrying out the first sintering on the solar cell that is formed with the lower layer of the sub-grid line such that the lower paste penetrates through a passivation coating of the solar cell and forming ohmic contact with a base silicon layer of the solar cell;
forming an upper layer of the sub-grid line and the main-grid line on the solar cell simultaneously using an upper paste by a second screen; and
carrying out the second sintering on the solar cell that is formed with the sub-grid line and the main-grid line, wherein the upper paste does not penetrate through the passivation coating of the solar cell during the second sintering.

9. The method according to claim 8, wherein the method further comprises a step of carrying out at least one time printing at the position on the solar cell where the sub-grid line needs to be provided using the upper paste by the first screen, following said step of forming the main-grid line and the upper layer of the sub-grid line on the solar cell simultaneously using the upper paste by the second screen.

10. The method according to claim 8 or 9, wherein a sintering temperature of the first sintering is higher than that of the second sintering.

11. The method according to claim 8 or 9, wherein the upper paste has a strengthened conductive characteristic.

12. The method according to claim 8 or 9, wherein the lower paste has been added with an element of Group V

13. The method according to claim 8 or 9, wherein a width of the sub-grid line is decreased upwardly from the lower layer thereof layer by layer.

14. A method of manufacturing a solar cell, **characterized by** comprising steps of forming a front electrode on the solar cell by the method according to any one of claims 1 to 13.

15. A solar cell, **characterized by** comprising a front electrode that is formed by the method according to any one of claims 1 to 13.
